# EUROPEAN PATENT APPLICATION

(11) **EP 1 426 965 A1**
(43) Date of publication of application: **09.06.2004**
(21) Application number: 02425747.9
(22) Date of filing: 04.12.2002
(51) Int. Cl.: G11C 7/06, G11C 16/28, G11C 11/56

(54) **Non volatile memory cell sensing circuit, particularly for low power supply voltages and high capacitive load values**

(71) Applicant: STMicroelectronics S.r.l., 20041 Agrate Brianza (Milano) (IT)
(72) Inventor: De Santis, Fabio, 20123 Milano (IT); Pasotti, Marco, 27028 San Martino Siccomario (Pavia) (IT); De Sandre, Guido, 20047 Brugherio (Milano) (IT)
(74) Representative: Ferrari, Barbara

(57) **Abstract**

The present invention relates to a sensing circuit (10, 100) for a memory cell (11) inserted between a first (Vdd) and a second voltage reference (GND) and connected, in correspondence with a first inner circuit node (XBL), to the memory cell (11) of the type comprising:
- a first bias current (Ip) generator (12) inserted between the first voltage reference (Vdd) and the first inner circuit node (XBL);
- a comparator (17) having a first input terminal (-) connected to a comparison circuit node (Xrif), connected in turn to the first voltage reference (Vdd) by means of at least a second reference current (Iref) generator (15), as well as a second input terminal (+) connected to a circuit node (Xmat) connected in turn to the first inner circuit node (XBL), an output terminal (OUT) of the comparator (17) corresponding to an output terminal of the sensing circuit (10).

Advantageously according to the invention, the sensing circuit comprises also:
- a cascode-configured bias circuit (13) inserted between the inner circuit node (XBL) and the matching circuit node (Xmat) and connected to a third voltage reference (Vref); and
- a current/voltage conversion stage (16) connected to the matching circuit node (Xmat) and to the comparison circuit node (Xrif), as well as to the second voltage reference (GND).

## Description

### Field of application

The present invention relates to a non volatile memory cell sensing circuit, particularly for low power supply voltages and high capacitive load values.

More specifically, the invention relates to a memory cell sensing circuit inserted between a first and a second voltage reference and connected, in correspondence with a first inner circuit node, to said memory cell comprising:
- a first bias current generator inserted between said first voltage reference and said first inner circuit node; and
- a comparator having a first input terminal connected to a comparison circuit node, connected in turn to said first voltage reference by means of at least a second reference current generator, as well as a second input terminal connected to a matching circuit node connected in turn to said first inner circuit node, an output terminal of said comparator corresponding to an output terminal of said sensing circuit.

The invention relates particularly, but not exclusively, to a memory cell sensing circuit of FLASH-type non volatile memory devices and the following description is made with reference to this field of application for convenience of illustration only.

### Prior art

As it is well known, the development of new improved processes for manufacturing non volatile memory cell devices in the CMOS technology field requires the use of lower and lower supply voltages, in some cases close to 1V.

In particular, so low supply voltage values are essential to use thinner and thinner oxides and in the meantime to limit as much as possible power consumptions (in the so-called "design low power" field).

Nevertheless, some needs which remained basically unchanged despite technology evolution contrast with these requirements.

On one hand, the need to bias memory cells with drain voltages being almost constant when technology varies (and equal to 1V) to keep the current passing through memory cells in the reading step high.

On the other hand, the need for low access times even with high capacitive loads due to the large memory cuts required.

These two factors make it difficult to manufacture a sensing circuit being capable of performing a correct bias and I/V conversion for a memory cell in a limited voltage range (Vx).

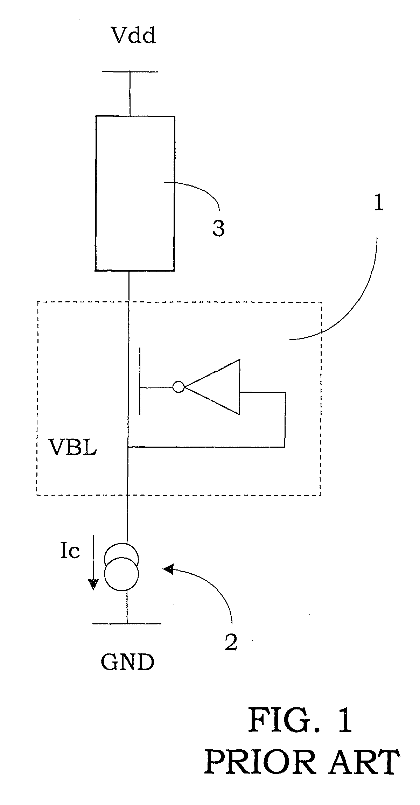

A known sensing circuit, with traditional memory cell bias, is schematically shown in figure 1 and it is globally indicated with 1. In particular, the sensing circuit 1 is connected to a non volatile memory cell, schematised by means of an equivalent current Ic generator 2, connected in turn to a first voltage reference, particularly the ground GND.

Moreover, the sensing circuit 1 is connected to a second voltage reference, particularly the supply Vdd, by means of a load 3.

It is worth noting that the following relation applies to the sensing circuit 1:$\text{Vx = Vdd - VBL}$ where Vdd indicates the circuit supply value and VBL the drain terminal bias voltage of the memory cell, corresponding to a voltage value in the contact point between the cell 2 and the sensing circuit 1.

In known memory devices, particularly in Flash memories, the voltage value Vx provided by the above-mentioned relation (1) can be equal, by way of example, even to only 200mv, the sensing circuit 1 being therefore difficult to be manufactured for a correct bias of load 3.

Moreover, in order to compensate for the reduced drive-capability due to the low supply voltage, it is often necessary to use particular transistors, such as natural transistors, which have however a higher cost linked to the number of process masks used for the manufacture thereof.

The technical problem underlying the present invention is to provide a sensing circuit for non volatile memory cells, but non only, capable to operate at low supply voltages and for high capacitive loads, having such structural and functional characteristics as to overcome the limits and drawbacks still affecting the circuits according to the prior art.

### Summary of the invention

The solution idea underlying the present invention is to manufacture a sensing circuit comprising a cascode-configured bias circuit and a high efficiency I/V converter, capable to operate at supply voltages very close, but not exclusively, to the values which are typical of the bias voltages of the cells manufactured with improved processes.

On the basis of this solution idea the technical problem is solved by a sensing circuit as previously described and defined in the characterising part of claim 1.

The features and advantages of the sensing circuit according to the invention will be apparent from the following description of an embodiment thereof given by way of non-limiting example with reference to the attached drawings.

### Brief description of the drawings

In the drawings:
Figure 1 schematically shows a sensing circuit according to the prior art;
Figure 2 schematically shows a sensing circuit according to the invention;
Figures 3A and 3B schematically show the time trend of voltage values in inner nodes of the sensing circuit of figure 2;
Figure 4 schematically shows an alternative embodiment of the sensing circuit according to the invention applied to general multilevel memories.

### Detailed description

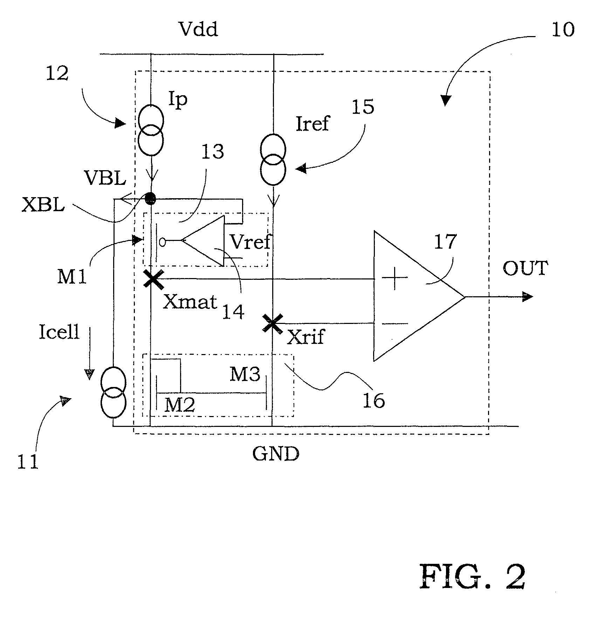

With reference to the drawings, and particularly to Figure 2, a sensing circuit according to the present invention is globally and schematically indicated with 10.

The sensing circuit 10 is inserted between a first voltage reference, particularly a supply voltage Vdd, and a second voltage reference, particularly a ground GND, and it is connected, in correspondence with an inner circuit node or bitline XBL, to a memory cell 11, schematically represented by means of a current Icell generator.

In particular, the sensing circuit 10 according to the invention comprises a bias current Ip generator 12 inserted between the supply voltage reference Vdd and the bitline XBL, connected in turn to a matching node Xmat by means of a cascode-configured bias circuit 13.

Advantageously according to the invention, the cascode-configured bias circuit 13 receives as input a voltage reference Vref. In particular, the cascode-configured bias circuit 13 comprises a transistor M1, of the P-channel MOS type, inserted between the bitline XBL and the matching node Xmat and having a gate terminal connected to an output terminal of an operational amplifier 14. The operational amplifier 14 has a first input terminal receiving the reference voltage Vrif and a second input terminal connected to the bitline XBL.

Moreover, a reference current Iref generator 15 is inserted between the supply voltage reference Vdd and a comparison node Xrif.

Advantageously according to the invention, the matching node Xmat and the comparison node Xrif are connected to the ground GND by means of a current/voltage conversion (I/V) stage 16. In particular, the I/V conversion stage 16 comprises a first N-channel MOS transistor M2, being diode-configured and inserted between the matching node Xmat and the ground GDN, as well as a second N-channel MOS transistor M3, inserted between the comparison node Xrif and the ground GND and having the gate terminal connected to the gate terminal of the first transistor M2.

The sensing circuit 10 comprises also a detecting circuit, particularly a comparator 17, having the input terminals advantageously connected to the matching node Xmat and to the comparison node Xrif. An output terminal OUT of the comparator 17 corresponds to an output terminal of the sensing circuit 10.

On the basis of the schematisation shown in figure 2, the operation of the sensing circuit 10 according to the invention will now be described.

The generator 12 supplies the current Ip for biasing the memory cell 11 connected to the bitline XBL during the reading phase, but also for biasing the conversion stage 16 through the transistor M1.

The difference between the bias current Ip of the generator 12 and the current Icell of the cell 11 with respect to the reference current Iref value of the generator 15 causes, thanks to the conversion stage 16 gain, a dynamic change of a voltage value Vrif on the comparison node Xrif.

In particular, advantageously, according to the invention, the voltage value Vrif is compared by means of the comparator 17 with a voltage value Vmat on the matching node Xmat, depending in turn on the voltage value of the memory cell 11 being read connected to the bitline XBL.

In the meantime, the cascode-configured bias circuit 13 performs a fixed bias of the bitline XBL even when the impedance of the memory cell 11 varies, due to the unknown state of the cell 11 being read (virgin or programmed cell). Therefore, advantageously, according to the invention, the conversion I/V stage 16 does not disturb the cell itself.

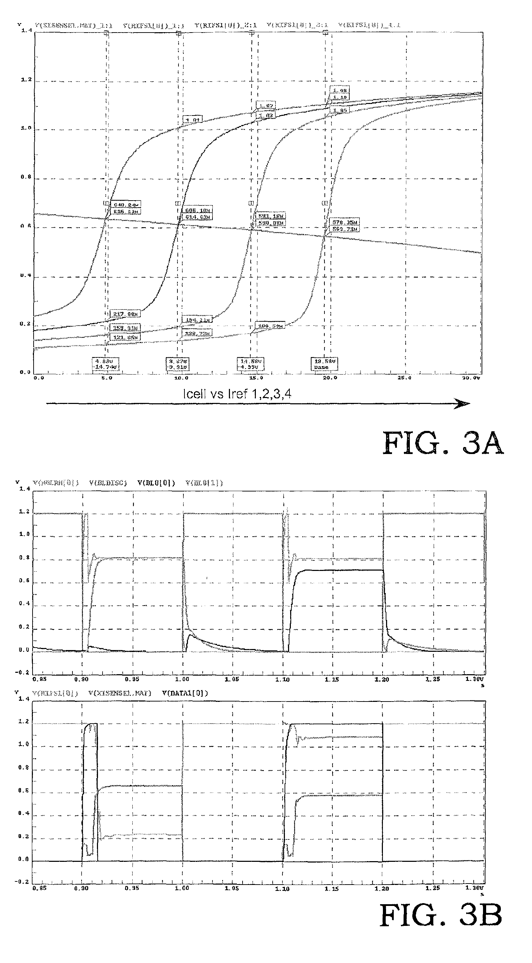

Figure 3A shows the trend of the output feature of the sensing circuit 10 according to the invention, i.e. the trend of the voltage Vrif on the comparison node Xrif with respect to the current Icell flowing in the cell 11 by using a supply voltage equal to 1.1 V and bias voltages of the bitline XBL equal to 800mV, as obtained from simulations carried out by the Applicant itself.

Similarly, figure 3B shows the time trend of the voltage values Vmat and Vrif on the matching node Xmat and on the comparison node Xrif, respectively, when the reference current Irif supplied by the generator 15 varies, and of the dynamic feature of the comparator 17 for programmed or virgin cell (output indicated in figure 3B with DATA1[0]).

On the basis of the results of these simulations (as shown in figure 3A), it must be promptly observed that the gain of the sensing circuit consisting of the set of the generator 12, of the cascode-configured bias circuit 13, of the generator 15 and of the I/V conversion stage 16 (except for the comparator 17) is high, particularly when the voltages to be compared are close to each other.

Moreover, the bias voltage VBL of the bitline XBL is not "lost" in the bias dynamics of the sensing circuit 10, as it happens instead in circuits according to the prior art. In fact, advantageously, according to the invention, the bias voltage VBL of the bitline XBL is exploited as dynamics for the conversion stage 16 and for the cascode-configured bias circuit 13.

In particular, the use of the cascode-configured bias circuit 13 inserted between the bias part of the bitline XBL (generator 12) and the conversion part (stage 16) makes the sensing circuit 10 according to the invention free with respect to the so-called drain disturb phenomenon and makes reading operations performed on the cell 11 more reliable.

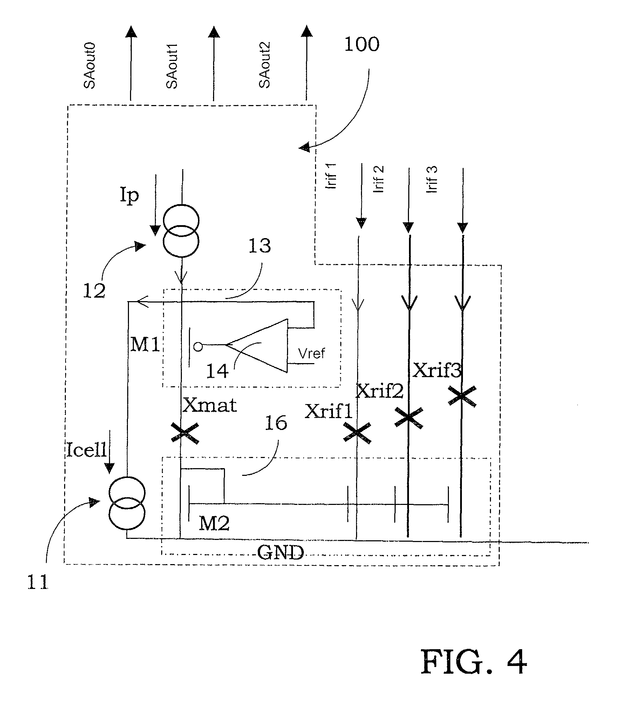

It is also possible to extend the operating principle of the sensing circuit 10 according to the invention to a multilevel application, as schematically shown in figure 4.

In particular, figure 4 shows a sensing circuit 100 used in two-bit per cell application for convenience of illustration, the principle according to the invention being further extendable to n bits per cell.

The sensing circuit 100 comprises a plurality of branches with a plurality of reference currents Irif1, Irif2, Irif3 connected to a plurality of inputs Xrif1, Xrif2, Xrif3 of an output comparator (not shown) having a further input terminal connected to the matching node Xmat and a plurality of output terminals Saout0, Saout1, Saout2.

In conclusion, the sensing circuit according to the invention allows the difficulties of known circuits to be overcome, not requiring in principle particular components and completely exploiting the supply voltage Vdd provided. In fact, the sensing circuit according to the invention does not limit the use of the circuitry thereof due to the fixed bias level of the bitline XBL.

In the meantime, the sensing circuit according to the invention allows a correct bias of the memory cell to be performed, and the reading voltage to be fixed, which is, as it is well know, a critical aspect to avoid reading drain disturb phenomena.

Finally, advantageously, with the sensing circuit according to the invention, the voltage level required to bias the memory device bitlines does not directly affect the definition of the residual voltage usable for the I/V conversion and for the stable definition of the bitline level, but it is parallel-exploited.

In fact the choice of drawing the cell current not serially, as in circuits according to the prior art, defining thus a fixed value which cannot be used for the sensing circuit, but parallelly takes to the advantage of exploiting all the bitline bias level, now close to the supply value, to perform both the I/V conversion and the cascode operation required to fix the bitline voltage and the capacitive decoupling.

## Claims

1. A sensing circuit (10, 100) for a memory cell (11) inserted between a first (Vdd) and a second voltage reference (GND) and connected, in correspondence with a first inner circuit node (XBL), to said memory cell (11) of the type comprising:
- a first bias current (Ip) generator (12) inserted between said first voltage reference (Vdd) and said first inner circuit node (XBL);
- a comparator (17) having a first input terminal (-) connected to a comparison circuit node (Xrif), connected in turn to said first voltage reference (Vdd) by means of at least a second reference current (Iref) generator (15), as well as a second input terminal (+) connected to a circuit node (Xmat) connected in turn to said first inner circuit node (XBL), an output terminal (OUT) of said comparator (17) corresponding to an output terminal of said sensing circuit (10);
**characterised in that** it comprises also:
- a cascode-configured bias circuit (13) inserted between said inner circuit node (XBL) and said matching circuit node (Xmat) and connected to a third voltage reference (Vref); and
- a current/voltage conversion stage (16) connected to said matching circuit node (Xmat) and to said comparison circuit node (Xrif), as well as to said second voltage reference (GND).

2. A sensing circuit according to claim 1, **characterised in that** said cascode-configured bias circuit (13) comprises a transistor (M1) inserted between said inner circuit node (XBL) and said matching circuit node (Xmat) as well as an operational amplifier (14) having a first input terminal connected to said third voltage reference (Vref) and a second input terminal feedback-connected to an output terminal, connected in turn to a control terminal of said transistor (M1).

3. A sensing circuit according to claim 2, **characterised in that** said transistor (M1) is of the P-channel MOS type.

4. A sensing circuit according to claim 1, **characterised in that** said current/voltage conversion stage (16) comprises a first transistor (M2), diode-configured and inserted between said matching circuit node (Xmat) and said second voltage reference (GND), as well as a second transistor (M3), inserted between said comparison circuit node (Xrif) and said second voltage reference (GND) and having a control terminal connected to a control terminal of said first transistor (M2).

5. A sensing circuit according to claim 4, **characterised in that** said first transistor (M2) and said second transistor (M3) are of the N-channel MOS type.

6. A sensing circuit according to claim 1, **characterised in that** it comprises a plurality of branches comprising a plurality of reference current (Irif1, Irif2, ..., Irifn) generators connected to a plurality of inputs (Xrif1, Xrif2, ... , Xrifn) of said comparator having a plurality of output terminals (Saout0), Saout1, ..., Saoutn).
